(19) Europäisches Patentamt
European Patent Office
Office européen des brevets

(11) **EP 2 529 239 B1**

(12) **FASCICULE DE BREVET EUROPEEN**

(45) Date de publication et mention
de la délivrance du brevet:
**25.02.2015 Bulletin 2015/09**

(21) Numéro de dépôt: **11700855.7**

(22) Date de dépôt: **27.01.2011**

(51) Int Cl.:
*G01Q 30/02* (2010.01)    *G01Q 10/06* (2010.01)
*H01L 41/04* (2006.01)

(86) Numéro de dépôt international:
**PCT/EP2011/051096**

(87) Numéro de publication internationale:
**WO 2011/092225 (04.08.2011 Gazette 2011/31)**

(54) **DISPOSITIF ELECTRONIQUE DE PILOTAGE ET D'AMPLIFICATION POUR UNE SONDE LOCALE PIEZOELECTRIQUE DE MESURE DE FORCE SOUS UN FAISCEAU DE PARTICULES**

ELEKTRONISCHE STEUERUNG UND VERSTÄRKUNGSVORRICHTUNG FÜR EINE LOKALE PIEZOELEKTRISCHE SONDE ZUR MESSUNG DER KRAFT UNTER EINEM PARTIKELSTRAHL

ELECTRONIC CONTROL AND AMPLIFICATION DEVICE FOR A PIEZOELECTRIC LOCAL PROBE FOR MEASURING FORCE BENEATH A PARTICLE BEAM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.01.2010 FR 1050633**

(43) Date de publication de la demande:
**05.12.2012 Bulletin 2012/49**

(73) Titulaire: **Commissariat à l'Énergie Atomique et aux Énergies Alternatives 75015 Paris (FR)**

(72) Inventeur: **POLESEL, Jérôme F-91190 Gif Sur Yvette (FR)**

(74) Mandataire: **Ilgart, Jean-Christophe et al Brevalex 95, rue d'Amsterdam 75378 Paris Cedex 8 (FR)**

(56) Documents cités:
**WO-A2-2009/085772**

- KIKUKAWA A ET AL: "Magnetic force microscope combined with a scanning electron microscope", JOURNAL OF VACUUM SCIENCE AND TECHNOLOGY A, vol. 11, no. 6, 1 novembre 1993 (1993-11-01), pages 3092-3098, XP000412888, ISSN: 0734-2101
- JAHNCKE C ET AL: "Choosing a preamplifier for tuning fork signal detection in scanning force microscopy", REVIEW OF SCIENTIFIC INSTRUMENTS, vol. 75, no. 8, 18 août 2004 (2004-08-18), pages 2759-2761, XP012072007, ISSN: 0034-6748
- SMIT R ET AL: "A low temperature scanning tunneling microscope for electronic and force spectroscopy", REVIEW OF SCIENTIFIC INSTRUMENTS, vol. 78, no. 11, 9 novembre 2007 (2007-11-09), pages 113705/1-5, XP012103717, ISSN: 0034-6748
- GROBER R D ET AL: "Fundamental limits to force detection using quartz tuning forks", REVIEW OF SCIENTIFIC INSTRUMENTS, vol. 71, no. 7, 1 juillet 2000 (2000-07-01), pages 2776-2780, XP012038401, ISSN: 0034-6748
- HEYDE M ET AL: "Double quartz tuning fork sensor for low temperature atomic force and scanning tunneling microscopy", REVIEW OF SCIENTIFIC INSTRUMENTS, vol. 75, no. 7, 1 juillet 2004 (2004-07-01), pages 2446-2450, XP012071689, ISSN: 0034-6748

EP 2 529 239 B1

**Description**

**DOMAINE TECHNIQUE**

La présente invention concerne un dispositif électronique de pilotage et d'amplification pour une sonde locale piézoélectrique de mesure de force sous un faisceau de particules.

**ÉTAT DE LA TECHNIQUE ANTÉRIEURE**

Le domaine de la présente invention est celui des électroniques de pilotage et d'amplification pour sondes locales de force piézoélectriques, pour une utilisation combinée sous l'illumination d'un faisceau électronique dans des microscopes électroniques à balayage ou transmission (SEM ou TEM) ou dans une sonde ionique focalisée (FIB), ou dans tout environnement comprenant la présence d'un faisceau de particules chargées à forte énergie. L'omniprésence de tels outils SEM, TEM et FIB pour l'industrie et la recherche fondamentale, qui est appliquée en microfabrication ou microélectronique, démontre l'intérêt d'un dispositif pour mesurer in situ les forces ou caractéristiques mécaniques et électroniques apparaissant dans les microsystèmes ou nanosystèmes électromécaniques (MEMS et NEMS) utilisés, à l'échelle sub-micrométrique, tout en visualisant en parallèle le système par microscopie champ lointain.

Les sondes locales de force de type microscope de force atomique (AFM) ont, depuis maintenant plus de vingt ans, démontré leur potentiel unique, pour caractériser des forces sur une gamme allant du microNewton jusqu'au picoNewton sur des sections de quelques nanomètres, via l'apex d'une micropointe, comme décrit dans le document référencé [1] en fin de description. Les systèmes de mesure de force AFM standards utilisent couramment une détection optique par laser de la déflexion d'un microlevier sondant la surface d'un échantillon via l'apex de la micropointe fixée au bout dudit microlevier. Cette technique de détection connue de l'homme du métier présente le désavantage d'être difficilement intégrable dans un milieu de fonctionnement contraint, tel que la chambre sous vide d'un microscope électronique SEM ou d'une sonde FIB. La sonde locale est donc contrainte sur plusieurs degrés de liberté dans l'espace. Le document référencé [2] décrit un système intégrant une sonde locale de mesures de force dans un microscope électronique SEM ou TEM ou une sonde FIB. Le document référencé [3] décrit l'intégration d'une sonde locale dans un tel microscope champ lointain.

Les sondes locales à capteurs intégrés permettent de résoudre les problèmes d'intégration et de mouvement. Comme décrit dans le document référencé [1], les sondes locales piézoélectriques permettent ainsi une détection sensible en force s'affranchissant d'un système à détection laser de la déflection. Une sonde résonante locale piézoélectrique peut se présenter sous la forme d'un quartz monolithique, ou d'un diapason, portant une micropointe qui sonde la surface de l'échantillon. Ce résonateur piézoélectrique est maintenu en oscillation. L'interaction micropointe-surface de l'échantillon provoque un changement des propriétés de résonance de ce résonateur piézoélectrique : amplitude d'oscillation, dérive de la fréquence de résonance, changement de l'énergie d'excitation. La mesure de ce changement de propriétés de résonance, par exemple la dérive en fréquence, permet, grâce à une calibration préalable, de connaître les forces mises en jeu sur l'échantillon scruté. Mais cela nécessite une mesure fine du courant électrique de déplacement généré par la sonde inférieure au nanoAmpère. Dans un environnement sous un faisceau de particules électriquement chargées (électrons dans un microscope électronique SEM ou TEM, ions dans une sonde ionique focalisée FIB), le courant d'émission créé dans l'échantillon par le faisceau empêche toute utilisation combinée avec la sonde locale piézoélectrique. Les préamplicateurs de l'art connu, tels que décrits par exemple dans le document référencé [4], ne permettent pas de surmonter ce problème de mesure fine du courant électrique de déplacement de la sonde, lorsque celle-ci est illuminée par le faisceau de particules électriquement chargées. De plus, sous l'illumination du faisceau de particules électriquement chargées, des problèmes de décharge électrostatique peuvent, à haute énergie, endommager les préamplificateurs utilisés pour mesurer le courant de déplacement de la sonde.

L'objet de l'invention est de résoudre ce problème technique en proposant un dispositif électronique de pilotage et d'amplification d'une sonde locale piézoélectrique de mesure de force permettant l'intégration et le fonctionnement de cette sonde sous un faisceau de particules chargées ou non dans un environnement se retrouvant notamment dans les microscopes électriques de type SEM ou TEM et les sondes ioniques focalisées FIB, comme utilisé classiquement en microélectronique et en microfabrication pour caractériser et usiner des puces et des micro- et nano-systèmes électromécaniques (MEMS, NEMS).

**EXPOSÉ DE L'INVENTION**

L'invention concerne un dispositif électronique de pilotage d'une sonde locale à résonateur piézoélectrique et de préamplification et traitement de ses signaux, cette sonde étant destinée à la mesure locale de propriétés physiques d'un échantillon dans un environnement présentant un faisceau de particules dirigé vers la sonde, caractérisé en ce que :

- une tension d'excitation générée par des moyens d'excitation est appliquée au résonateur piézoélectrique via un premier transformateur d'isolation galvanique, et en ce qu'un courant de mesure des oscillations mécaniques du résonateur piézoélectrique est appliqué via un second transformateur d'isolation galvanique à des moyens de préamplification situés en aval,

- les premier et second transformateurs ont une tension de claquage primaire/secondaire suffisament élevée pour supporter la surtension produite par le faisceau de particules,
- les bobinages des transformateurs présentent des impédances suffisament faibles pour que le courant électrique, provoqué dans les éléments conducteurs par l'impulsion électrique induite par le faisceau de particules, soit inapte à la détérioration du premier étage des moyens de préamplification placés en aval.

De manière préférentielle, tous les enroulements de ces transformateurs ont un pôle relié à la masse, ou à une masse virtuelle, c'est-à-dire une entrée d'un amplificateur opérationnel dont l'autre entrée est reliée à la masse.

Le faisceau de particules peut être un faisceau de particules électriquement chargées, par exemple un faisceau électronique ou ionique, ou un faisceau constitué de particules électriquement neutres du type atomes ou neutrons.

Lorsque le faisceau de particules induit une impulsion électrique, cette source parasite se comporte comme une source de courant d'impédance extrêmement élevée (de l'ordre de 10 ou 100 MOhms, voire bien plus). La tension de claquage primaire/secondaire des transformateurs selon l'invention est choisie supérieure à la tension induite par le produit de ce courant par l'impédance de l'enroulement du transformateur.

Toutefois, cette tension induite s'effondre dès que l'impulsion électrique est reçue par un élément de conducteur électrique, puisqu'il est galvaniquement connecté, selon l'invention, à un enroulement de très basse impédance en continu (quelques Ohms, et préférentiellement une fraction d'Ohm). La tension résultante aux bornes de cet élément de conducteur se trouve divisée par le rapport entre les impédances (par exemple $100.10^6/0,5$) c'est-à-dire une tension quasi nulle. Il va de soi que, selon l'invention, cette tension doit être inférieure à la tension de claquage de l'entrée du préamplificateur. Toutefois cette condition évidente n'est pas explicitée dans la revendication car elle se trouve toujours réalisée avec la désadaptation d'impédance exposée ci-dessus : cette tension induite aux bornes de l'enroulement très basse impédance du transformateur est typiquement de l'ordre du $\mu V$. Grâce à cette désadaptation, l'impulsion induite par le faisceau de particules chargées sur l'électrode de la sonde locale à résonateur piézoélectrique reliée à l'enroulement du transformateur n'est plus qu'une tension induite (de l'ordre du $\mu V$) bien en deçà de la tension de claquage de l'entrée du préamplificateur.

Le courant parasite très faible, lorsque le faisceau de particules induit une impulsion électrique, est appliqué aux bornes du résonateur piézoélectrique contenu dans la sonde, dont l'impédance d'entrée est de l'ordre de 100 M$\Omega$ hors de la résonance, et 10 K$\Omega$ à la

résonance. Toutefois cette dernière étant très pointue, on peut considérer que l'énergie due au faisceau de particules couvre majoritairement le résonateur piézoélectrique en dehors de sa fréquence propre, c'est à dire sous 100 M$\Omega$. La faible impédance du bobinage du transformateur qui lui est reliée, de l'ordre de quelques ohms, et préférentiellement inférieure à un ohm, ne lui permet d'appliquer qu'une tension extrêmement faible.

Selon l'invention, la tension induite par ce courant extrêmement faible (typiquement de l'ordre du $\mu A$ et préférentiellement inférieur) doit être dimensionnée par le choix des composants pour ne pas induire de détérioration sur l'étage d'entrée des moyens de préamplification. Habituellement, ces derniers sont à transistors FET, et leurs caractéristiques de claquage électrique sont connues.

Les transformateurs d'isolation galvanique sont choisis de manière à être adaptés à la bande de fréquence du résonateur piézoélectrique. Les paramètres à prendre en compte pour le résonateur piézoélectrique sont sa fréquence de résonance f0 et son facteur de qualité Q=f0/Df, Df étant la largeur de bande à -3dB de sa courbe de résonance en amplitude. Pour chaque bobinage l'inductance primaire, la résistance DC, la capacité interbobinage (entre le primaire et le secondaire), l'inductance de fuite et le produit tension.temps sont des paramètres déterminants pour accorder la réponse en fréquence des tranformateurs autour de la fréquence de résonance fo du résonateur piézoélectrique. L'inductance $L_{prim}$ du bobinage primaire du transformateur est le principal paramètre déterminant la fréquence de coupure basse $f_l$ du transformateur, la résistance DC du bobinage participant de manière mineure.

$f_l$ est définie par :

$$f_l = X_{lmin}/(2*pi*L_{prim})$$

avec $L_{prim}$ l'inductance du primaire, et $X_{lmin}$ la réactance minimum pour atteindre une atténuation G (en dB) de l'amplitude du signal à la fréquence $f_l$. Cette réactance dépend de la résistance de la source d'entrée, tel que :

$$X_{lmin}=Rg/(2*\sqrt{(A^2-1)})$$

où Rg est la résistance de la source de tension, et $A=10^{(G/20)}$

La fréquence de coupure haute $f_h$ du transformateur est déterminée par l'inductance de fuite $L_{leak}$, et la capacité interbobinage $C_i$ tel que :

$$fh = 1/(2*pi*\sqrt{(L_{leak}*C_i)})$$

La saturation du coeur magnétique du transformateur peut induire une distorsion du signal sortant du secondaire. Le produit tension.temps (« E.T constant » en anglais) notée $K_{ET}$ permet pour une amplitude donnée en volts du signal entrant sur le primaire, de fournir la limitation de la fréquence du signal qui pourra transiter dans le transformateur sans effet de distorsion, tel que :

$$K_{ET} = U \star T$$

U étant l'amplitude en volts du signal entrant et T sa période en microsecondes. Le paramétrage théorique ou bien la mesure expérimentale des paramètres dynamiques du transformateur sont bien connus de l'homme du métier. Concernant les méthodes de calculs pour paramétrer la bande passante en fréquence du transformateur on peut par exemple utiliser le document référencé [6]. Pour simuler numériquement le transformateur en basse et haute fréquence, sur un moteur de simulation numérique SPICE par exemple, le document référencé [7] propose un modèle équivalent admis et connu de l'Homme du Métier. Des méthodes de caractérisation expérimentale des paramètres dynamiques du transformateur sont données dans le document référencé [8].

Avantageusement, le premier transformateur est un transformateur à point symétrique, qui présente un rapport de nombre de tours de bobinage 1:1+1.

Avantageusement, le second transformateur présente un rapport de nombre de tours de bobinage 1:1, avec les mêmes caractéristiques électriques que le premier tranformateur. En cela, la tension de sortie au(x) secondaire(s) des transformateurs sera égale en module à la tension d'entrée appliquée au primaire des transformateurs. Ces caractéristiques des deux transformateurs permettent une réponse de gain unitaire de type passe-bande dans une plage en fréquence comprise autour de la résonance f0 du résonateur piézoélectrique et supérieure à la largeur de bande Df à -3dB de la courbe de résonance en amplitude du résonateur piézoélectrique.

Les transformateurs d'isolation galvanique peuvent supporter un choc électrique provoqué par un faisceau de particules dirigé sur la sonde. Le courant d'émission produit par le faisceau de particules dirigé vers la sonde et l'échantillon est pris en compte pour définir la tension de claquage minimum et le courant d'impulsion maximum que présent ces deux transformateurs.

Avantageusement, les bobinages des transformateurs d'isolation galvanique présentent une basse impédance d'entrée au courant d'émission généré dans la sonde par le faisceau de particules chargées. La tension générée ainsi aux bornes du bobinage primaire est égale au produit de l'impédance du bobinage par le courant d'émission dû à la présence du faisceau sur la sonde piézoélectrique. Avec une résistance en continu de l'ordre d'un ohm et préférentiellement inférieure, la tension induite par le faisceau de particules est au maximum égale au microVolt. Par ailleurs, la composante basse fréquence, presque DC, de la tension sur le primaire du transformateur, provoquée par la présence du faisceau de particules chargées, est supprimée aux bornes du bobinage secondaire par l'isolation galvanique du transformateur. Ainsi, tout risque de charge de claquage sur l'entrée haute impédance de l'amplificateur opérationnel de sortie est évité.

En ce qui concerne l'éventualité d'un claquage électrique interne aux transformateurs d'isolation galvanique, ce claquage n'apparaît que pour une différence de potentiel seuil entre les deux bobinages (primaire et secondaire de chaque transformateur) séparés par une isolation électrique. Cette différence de potentiel devant être inférieure à la tension de claquage donnée dans la fiche technique du constructeur dudit transformateur. Avantangeusement, ce problème est évité dans la présente invention par la connection au même potentiel électrique de masse des bobinages primaire et secondaire des deux transformateurs d'isolation galvanique.

Avantangeusement la sonde est munie d'une micropointe conductrice apte à la mesure de forces, l'extrémité de cette micropointe étant dotée d'un revêtement inorganique ou organique contrôlé pour accroître la sélectivité des forces mesurées.

Avantageusement l'échantillon est polarisé par rapport à la sonde, l'échantillon étant électriquement relié à un convertisseur courant/tension afin de mesurer des propriétés physiques entre la pointe et l'échantillon comme la conductance, le courant tunnel.

Avantageusement le dispositif de l'invention comprend des moyens pour détecter la force électrostatique entre l'échantillon et la sonde par mesure EFM (i.e. « Electrostatic Force Microscopy ») ou par mesure KPFM (i.e. Sonde de Kelvin) connues de l'Homme du métier.

Avantageusement la sonde est munie d'une micropointe portant à son apex une microsphère d'un matériau magnétique rémanent aimanté permettant la mesure locale de forces magnétiques sur l'échantillon par mesure MFM (i.e. « Magnetic Force Microscopy ») connue de l'Homme du métier.

Avantageusement l'apex de la sonde est muni d'un thermocouple ou d'un fil de polymère pour effectuer une thermographie locale de l'échantillon à gradient de force constant ou à distance *pointe-surface* constante.

Dans un premier exemple de réalisation avantageux, le dispositif de l'invention comprend :

- un étage d'excitation de très faible tension comprenant un premier amplificateur opérationnel dont l'entrée non-inverseuse + est reliée à la masse, dont l'entrée inverseuse - est reliée à un générateur au travers une première résistance et à une extrémité d'une seconde résistance, et dont la sortie est reliée à l'autre extrémité de la seconde résistance,

- une première isolation galvanique comprenant un premier transformateur à point symétrique relié à la sortie du premier amplificateur opérationnel au travers une troisième résistance d'un étage d'adaptation d'impédance, dont la capacité est reliée à la masse, la première extrémité du secondaire de ce premier transformateur étant reliée à la masse au travers d'une capacité ajustable, la seconde extrémité du secondaire de ce premier transformateur étant connectée à une première électrode d'un résonateur piézoélectrique dont la seconde électrode est reliée à la micropointe et à la masse,

- une seconde isolation galvanique comprenant un second transformateur dont une extrémité du primaire est reliée au point milieu du secondaire du premier transformateur, l'autre extrémité étant reliée à la masse, et dont une première extrémité de secondaire est reliée à la masse au travers une quatrième résistance,

- un premier étage de préamplification comprenant un second amplificateur opérationnel dont l'entrée non-inverseuse + est reliée à la masse et dont l'entrée inverseuse - est reliée à la seconde extrémité du secondaire du second transformateur au travers une capacité et à une extrémité d'une cinquième résistance dont l'autre extrémité est reliée à la sortie de ce second amplificateur opérationnel,

- un second étage d'amplification comprenant un premier amplificateur différentiel d'instrumentation relié à la sortie du second amplificateur opérationnel au travers une sixième résistance.

Dans un second exemple de réalisation il comprend, en outre :

- un premier étage de préamplification comprenant un troisième amplificateur opérationnel et une résistance de conversion courant-tension reliée entre son entrée inverseuse - et sa sortie, l'entrée inverseuse - de ce troisième amplificateur opérationnel étant aussi reliée à l'échantillon et l'entrée non-inverseuse + de ce troisième amplificateur opérationnel étant reliée à une source de tension pour polariser l'échantillon par rapport à la masse,

- un second étage d'amplification comprenant un second amplificateur différentiel d'instrumentation.

Le dispositif de l'invention est très simple à intégrer et à utiliser sur un microscope électronique SEM ou TEM, ou bien sur une sonde FIB. Le dispositif de l'invention permet d'éliminer les artefacts de mesure mécanique locale liés à l'illumination de la sonde par le faisceau de particules chargées.

Les applications visées par l'invention concernent la caractérisation fine et *in situ* des microsystèmes ou nanosystèmes électromécaniques MEMS et NEMS sur plaquette, ou « wafer », ou montés sur boîtier, mais aussi la microélectronique avec caractérisation combinée force-courant électrique. Le dispositif de l'invention présente, par exemple, un intérêt dans la caractérisation des accéléromètres qui sont de plus en plus sensibles et petits. De même un usinage *in situ* par sonde FIB de microstructures peut aussi être envisagé avec la possibilité d'avoir un retour de force, en temps réel, grâce à la présente invention permettant d'ajuster et de corriger la position du faisceau ionique focalisé.

Le remplacement, à l'extrémité de la sonde piézoélectrique, de la micropointe par une microsonde magnétique ou un thermocouple permet également d'envisager respectivement une mesure sur des mémoires magnétiques ou bien une cartographie thermique d'un microprocesseur en fonctionnement, avec un retour de force permettant d'ajuster la distance entre microsonde et surface de l'échantillon avec une précision sub-nanométrique. Il faut remarquer qu'une telle précision est inatteignable grâce à la résolution d'un microscope électronique SEM, bien qu'un tel microscope permette un positionnement assez précis de la sonde.

## BRÈVE DESCRIPTION DES DESSINS

La figure 1 illustre un premier mode de réalisation du dispositif de l'invention.
La figure 2 illustre un second mode de réalisation du dispositif de l'invention.
La figure 3 illustre un exemple de réalisation du premier mode de réalisation du dispositif de l'invention illustré sur la figure 1.
La figure 4 illustre un exemple de réalisation du second mode de réalisation du dispositif de l'invention illustré sur la figure 2.
Les figures 5A et 5B illustrent respectivement une vue globale d'un exemple de réalisation du dispositif de l'invention mis sous boîtier et prêt à être utilisé, et un détail d'une telle mise sous boitier.
Les figures 6A à 6E sont des images illustrant un exemple d'application du dispositif de l'invention.

## EXPOSÉ DÉTAILLÉ DE MODES DE RÉALISATION PARTICULIERS

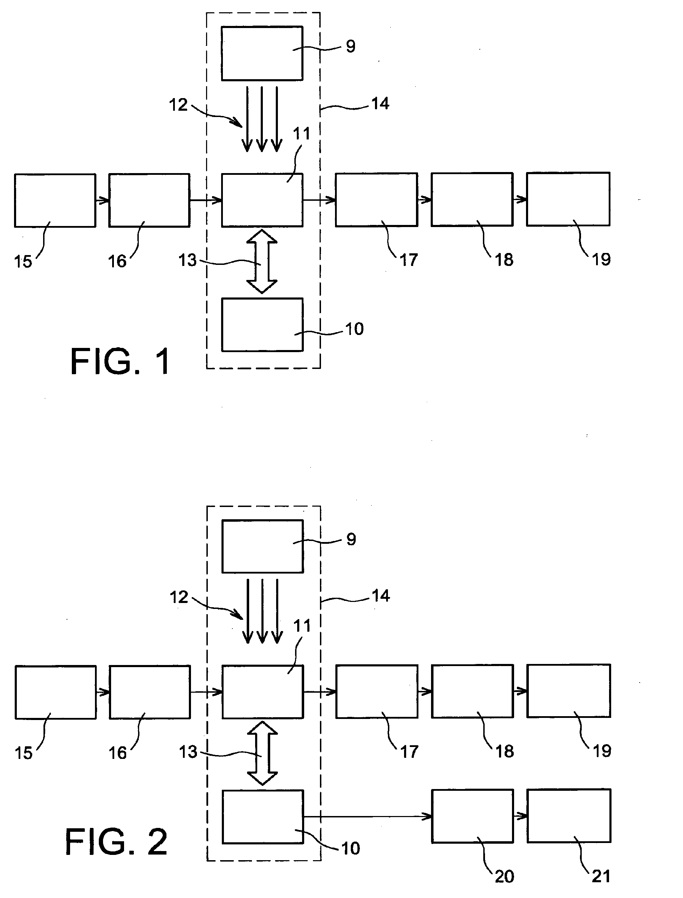

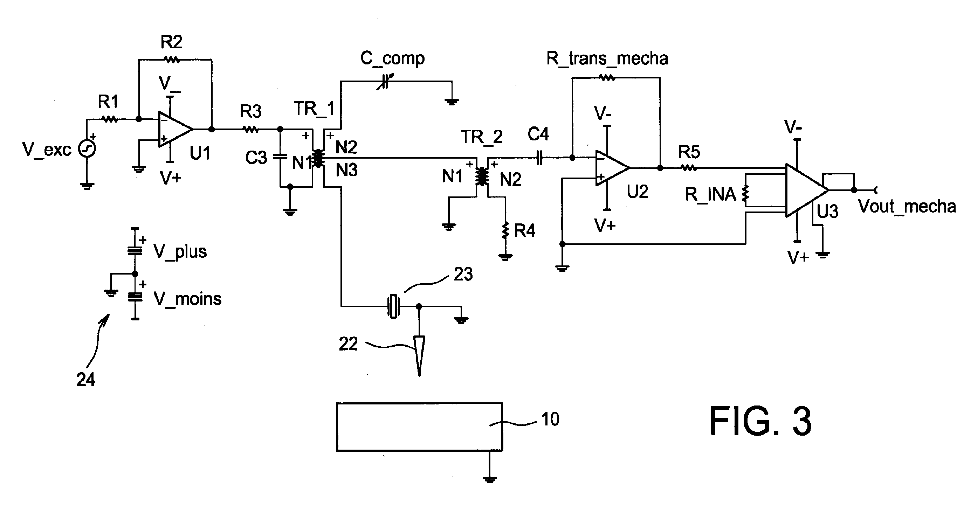

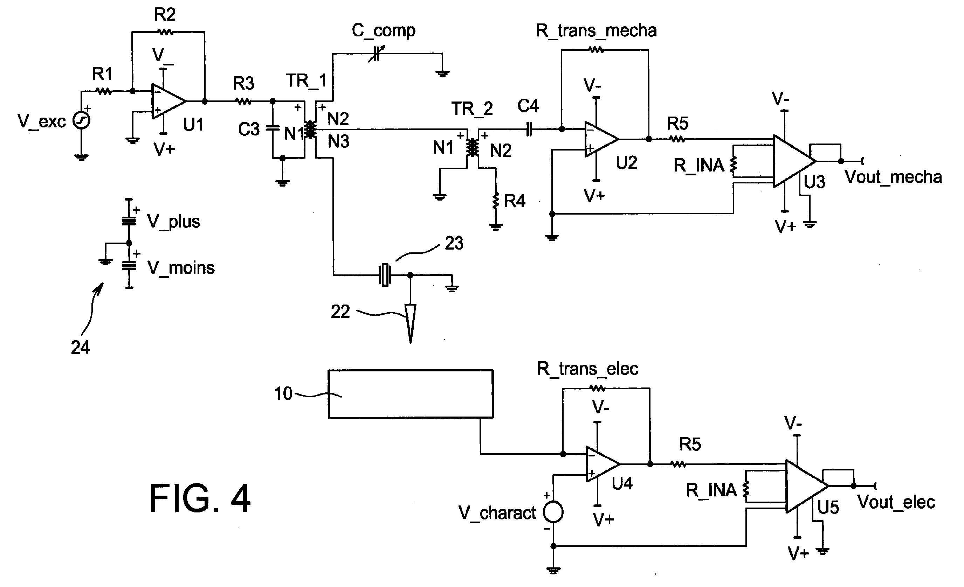

La figure 1 illustre un premier mode de réalisation du dispositif de l'invention permettant une mesure locale des propriétés mécaniques (force, contrainte, pression) sur un échantillon 10 avec une sonde piézoélectrique 11 munie d'une micropointe (« tip ») dans un environnement 14 présentant un faisceau de particules chargées électriquement 12 (microscope électronique SEM ou TEM ou sonde ionique localisée FIB) orienté vers la sonde piézoélectrique 11 et l'échantillon 10, avec une interaction entre la micropointe 22 (figurée sur les schémas des figures 3 et 4) et l'échantillon 10 représentée par une double flèche 13.

Ce premier mode de réalisation comprend les modules suivantes :

- un étage 15 d'excitation de très faible tension,
- une première isolation galvanique 16,
- une seconde isolation galvanique 17,
- un premier étage 18 de préamplification (amplificateur courant-tension dit transimpédance) de caractérisation mécanique locale,
- un second étage 19 d'amplification de caractérisation mécanique,

les modules 11, 15, 16, 17, 18 et 19 permettant donc une caractérisation mécanique locale.

Ce premier mode de réalisation permet d'obtenir une isolation totale entre le courant de déplacement à haute fréquence de la sonde locale pour mesurer simultanément son mouvement mécanique d'oscillation, et le courant d'émission généré par le faisceau de particules électriquement chargées à flux continu. Une caractérisation par imagerie SEM, TEM ou FIB, tout en mesurant simultanément des forces locales à l'échelle de quelques picoNewtons, devient alors possible. L'absence de détection externe, comme dans le cas de la détection laser AFM, permet à la sonde locale piézoélectrique de jouir de degrés de liberté en mouvement dans les trois dimensions. L'imagerie champ lointain (SEM, TEM ou FIB) aide au placement judicieux de la sonde locale pour la mesure des propriétés mécaniques de l'échantillon. Ainsi, un usinage par sonde FIB d'une microstructure tridimensionnelle, tout en mesurant, des forces, pressions ou contraintes locales en parallèle sur l'échantillon, devient aussi possible. Le retour d'effort peut aider au repositionnement optimum du faisceau ionique de la sonde FIB.

Un second mode de réalisation illustré sur la figure 2 permet, outre la mesure locale des propriétés mécaniques (force, contrainte, pression) sur l'échantillon 10 à l'aide de la sonde piézoélectrique 12 dans un environnement 14 présentant un faisceau de particules électriquement chargées, une mesure locale des propriétés électroniques (conductance, courant tunnel) sur ce même échantillon 10.

Ce second mode de réalisation comprend, en plus des modules 10-12 et 15-19 déjà illustrés sur la figure 1 :

- un premier étage de préamplification 20 (amplificateur courant-tension dit transimpédance), de caractérisation électrique locale,
- un second étage 21 d'amplification de caractérisation électrique locale,

les modules 10, 11, 15, 16, 20 et 21 permettant donc une caractérisation électrique locale.

Ce second mode de réalisation permet d'effectuer des mesures simultanées de force et de courant électronique local entre la micropointe 22 et l'échantillon 10. L'échantillon est ainsi polarisé par une tension externe et relié à l'étage 20 de préamplification courant-tension (dit transimpédance), le faisceau de particules électriquement chargées étant éteint pour ne pas perturber cet étage de préamplication 20 relié à l'échantillon. La régulation en force de la sonde piézoélectrique 11 permet de conserver une distance constante par rapport à l'échantillon 10 durant la mesure électrique. La caractérisation conductance électrique-contrainte locale $\sigma(\varepsilon)$ devient alors possible dans l'environnement d'un microscope électronique SEM sur des échantillons piézorésistifs, qui sont très utilisés dans les microsystèmes ou nanosystèmes électromécaniques MEMS et NEMS. La cartographie électrique d'une puce en fonctionnement est également envisageable avec ce second mode de réalisation.

## EXEMPLES DE REALISATION

a) Dispositif électronique pour la mesure locale des propriétés mécaniques d'un échantillon

Ce premier exemple de réalisation, illustré sur la figure 3, correspond à une mise en oeuvre du premier mode de réalisation illustré sur la figure 1.

Ce dispositif comprend :

- un étage d'excitation de très faible tension comprenant un premier amplificateur opérationnel U1 dont l'entrée non-inverseuse + est reliée à la masse, dont l'entrée inverseuse - est reliée à un générateur Vexc au travers une première résistance R1 et à une extrémité d'une seconde résistance R2, et dont le sortie est reliée à l'autre extrémité de la seconde résistance R2,

- une première isolation galvanique comprenant un premier transformateur à point symétrique TR_1 relié à la sortie du premier amplificateur opérationnel U1 au travers une troisième résistance R3 d'un étage d'adaptation d'impédance R3, C3, dont la capacité C3 est reliée à la masse, la première extrémité du secondaire de ce transformateur étant reliée à la masse au travers d'une capacité ajustable C_comp, la seconde extrémité du secondaire de ce transformateur étant connectée à une première électrode d'un résonateur piézoélectrique 23 dont la seconde électrode est reliée à la micropointe 22 et à la masse,

- une seconde isolation galvanique comprenant un second transformateur TR_2 dont une extrémité du primaire est relié au point milieu du secondaire du premier transformateur TR_1, l'autre extrémité étant reliée à la masse, et dont une première extrémité du secondaire est reliée à la masse au travers une quatrième résistance R4,
- un premier étage de préamplification comprenant un second amplificateur opérationnel U2 transimpédance dont l'entrée non-inverseuse + est reliée à la masse et dont l'entrée inverseuse - est reliée à la seconde extrémité du secondaire du second transformateur TR_2 au travers une capacité C4 et à une extrémité d'une cinquième résistance R_trans_mecha dont l'autre extrémité est reliée à la sortie de ce second amplificateur opérationnel U2,

- un second étage d'amplification comprenant un premier amplificateur différentiel d'instrumentation U3, avec une résistance de gain R_INA, relié à la sortie du second amplificateur opérationnel U2 au travers une sixième résistance R6.

Les bobinages primaire et secondaire des deux transformateurs TR_1 et TR_2 sont connectés au même potentiel de masse (cela inclut la masse virtuelle d'une entrée d'amplificateur opérationnel dont l'autre entrée est à la masse).

L'étage d'excitation comprenant le premier amplificateur opérationnel U1 et les résistances R2 et R1 est un diviseur de tension permettant d'exciter la sonde résonante piézoélectrique 23 avec de très petites amplitudes d'oscillation à la fréquence de résonance allant de quelques dizaines de kiloHertz à plusieurs dizaines de mégaHertz. Des amplitudes d'oscillations de l'ordre de l'Angström (0.1 nm) garantissent une très grande sensibilité de détection des forces tout en ne perturbant pas de manière significative l'échantillon sondé. L'étage d'adaptation d'impédance R3-C3 permet une adaptation d'impédance optimisée sur le premier transformateur d'isolement TR_1. Ce transformateur TR_1 permet d'une part de transmettre l'excitation électrique sur le résonateur piézoélectrique 23, mais aussi d'éliminer les effets de capacité parasite, connus de l'homme du métier, liée à la capacité inter-électrodes du résonateur piézoélectrique mais aussi à la longueur des fils de connexion de la sonde, grâce au réglage de la capacité ajustable C_comp. La réponse mécanique du résonateur piézoélectrique 23 en interaction avec l'échantillon 10 provoque une modification du courant électrique de déplacement transmis par le même fil sur le second transformateur d'isolement TR_2. Le secondaire de ce transformateur TR_2 transmet donc ce courant de déplacement sur le second amplificateur opérationnel U2 avec la résistance de conversion courant-tension R_trans_mecha. Le réseau R4-C4 permet une adaptation d'impédance optimisée avec le second transformateur TR_2. Le premier amplificateur différentiel d'instrumentation U3 permet de délivrer une tension exploitable par une chaîne de mesure en aval pour extraire les modifications des propriétés de résonance du résonateur piézoélectrique 23 en interaction avec l'échantillon 10, et donc de remonter aux mesures mécaniques locales. La présence des deux transformateurs d'isolement TR_1 et TR_2 agit comme une barrière électrique qui évite une contamination du signal utile par la présence du faisceau de particules électriquement chargées sur la sonde, dans l'enceinte SEM, TEM ou FIB. La mise à la masse de la micropointe 22 via une électrode du résonateur piézoélectrique 23 et de l'échantillon 10 permet une évacuation des charges électriques dues au faisceau de particules électriquement chargées et évite donc l'apparition de forces électrostatiques perturbantes entre la micropointe 22 et l'échantillon 10.

Le transformateur TR_2 présente l'avantage de présenter une basse impédance d'entrée au signal provenant de la sonde piézoélectrique 11 exposée au faisceau de particules chargées. La tension générée ainsi aux bornes du bobinage primaire du transformateur TR_2 est égale au produit de l'impédance du bobinage par le courant d'émission dû à la présence du faisceau sur la sonde piézoélectrique. On trouve ainsi une tension au maximum égale au microVolt, la résistance DC du bobinage étant de l'ordre de l'ohm. Lors d'opérations en Microscopie Electronique à Balayage (SEM), une fraction d'électrons secondaires ne s'échappant pas de l'échantillon s'écoule par la masse électrique. Ces électrons secondaires étant provoqués par le faisceau d'électrons à haute énergie. Ce courant peut être mesuré en plaçant un ampèremètre entre l'échantillon et la masse. Ce courant dit « absorbé » ou de « sonde » ou d'émission varie de l'ordre du picoAmpère jusqu'au microAmpère, au maximum. Pour plus de détails sur ce courant d'émission, on peut se référer par exemple au documents référencés [9] ou [10].

Par ailleurs, la composante basse fréquence, presque DC, de la tension sur le primaire du transformateur TR_2, provoquée par la présence du faisceau de particules chargées 12, est supprimée aux bornes du bobinage secondaire du transformateur TR_2 par l'isolation galvanique du transformateur. Ainsi, tout risque de charge de claquage sur l'entrée haute impédance de l'amplificateur opérationnel U2 est évité. Sans la présence de l'isolation galvanique à basse impédance du transformateur, le transitoire électrique du courant d'émission provoqué par l'allumage du faisceau de particules chargées sur la sonde pourrait provoquer une charge de claquage sur l'entrée haute impédance de l'amplificateur opérationnel de sortie (typiquement de l'ordre du TeraOhm pour un amplificateur du type OPA657 de la société Burr Brown). L'étage d'entrée de l'amplificateur opérationnel de sortie U2 est communément équipé de transistors FET dotés de grille d'oxyde de quelques dizaines de nanomètres, sensibles à un claquage diélectrique à partir d'une tension appliquée de quelques volts. La charge de claquage étant proportionnelle à l'épaisseur de cette grille d'oxyde. Pour plus de détails sur le phénomène de claquage des grilles d'oxydes des transistors FET, on peut se référer par exemple aux documents référencés [11] ou [12].

De la même manière, le transformateur TR_1 permet la suppression de la composante basse fréquence, presque DC, de la tension créée sur son secondaire, provoquée par la présence du faisceau de particules chargées 12 sur la sonde 11. Ainsi ce signal n'apparaît pas au primaire de TR_1 évitant de perturber la sortie de l'amplificateur U1, via la résistance R3.

En ce qui concerne l'éventualité d'un claquage électrique interne aux transformateurs TR_1 ou TR_2, ce claquage n'apparaît que pour une différence de potentiel seuil entre les deux bobinages (primaire et secondaire de chaque transformateur) séparés par une isolation électrique. Cette différence de potentiel devant être inférieure à la tension de claquage donnée dans la fiche technique du constructeur dudit transformateur. Dans la présente invention, on note sur les schémas électriques des figures 3 et 4 que les bobinages primaires et secondaires du transformateur TR_1 sont directement reliés à la même masse électrique. Ainsi, dans le régime basse fréquence, presque DC, d'utilisation du faisceau de particules chargées 12 sur la sonde 11, le primaire et le secondaire de TR_1 sont reliés au même potentiel, donc non sujet à un claquage électrique. Pour le transformateur TR_2, on constate aussi une connexion directe de son bobinage primaire à la masse ; son bobinage secondaire étant relié à la même masse via la résistance R4. En considérant un régime DC, ou basse fréquence, où la capacité C4 peut être assimilée à un circuit ouvert, ou bien dans un régime haute fréquence où la capacité C4 peut être assimilée à un circuit fermé sur la masse virtuelle fournie par l'entrée inverseuse - de l'amplificateur U2, on note que le bobinage secondaire est aussi au même potentiel électrique que le bobinage primaire du transformateur TR_2. Le risque de claquage électrique pour TR_2 est aussi donc évité dans ces conditions.

Par précaution, on prend quand même une certaine valeur pour le seuil de claquage des transformateurs pour éviter tout claquage lors du transitoire électrique provoqué par l'allumage du faisceau électronique 12 sur la sonde 11. La valeur seuil de 2 kiloVolts des transformateurs TR_1 et TR_2, utilisés dans Mise en oeuvre concrète du dispositif de l'invention, satisfait à cette exigence.

**b) Dispositif électronique pour la mesure locale des propriétés mécaniques et électriques d'un échantillon**

Ce second exemple de réalisation, illustré sur la figure 4, correspond à une mise en oeuvre du second mode de réalisation illustré sur la figure 2.
Cet exemple comprend, en outre les éléments déjà illustrés sur la figure 3 :

- un premier étage de préamplification comprenant un troisième amplificateur opérationnel U4 transimpédance et une résistance de conversion courant-tension R_trans_elec reliée entre son entrée inverseuse- et sa sortie, l'entrée de ce troisième amplificateur opérationnel étant reliée à l'échantillon 10,
- un second étage d'amplification comprenant un second amplificateur différentiel d'instrumentation U5 avec une résistance de gain R_INA.

Ce second exemple de réalisation reprend la structure du premier exemple de réalisation à la différence que l'échantillon, au lieu d'être mise à la masse, est polarisé par une tension V_charact par sa connexion à l'amplificateur U4 et à la résistance de conversion courant-tension R_trans_elec. L'amplificateur différentiel d'instrumention U5 permet de délivrer une tension exploitable par une chaîne de mesure en aval pour extraire le courant micropointe-surface de l'échantillon pour une tension V_charact donnée, et donc de remonter aux mesures électroniques locales de conduction.
Des mesures capacitives sur des microsystèmes ou sur une puce peuvent aussi être envisagées dans un microscope électronique SEM avec le dispositif de l'invention illustré sur la figure 4 en utilisant la technique EFM (« Electrostatic Force Microscopy ») décrite dans le document référencé [5].

Mise en oeuvre concrète du dispositif de l'invention

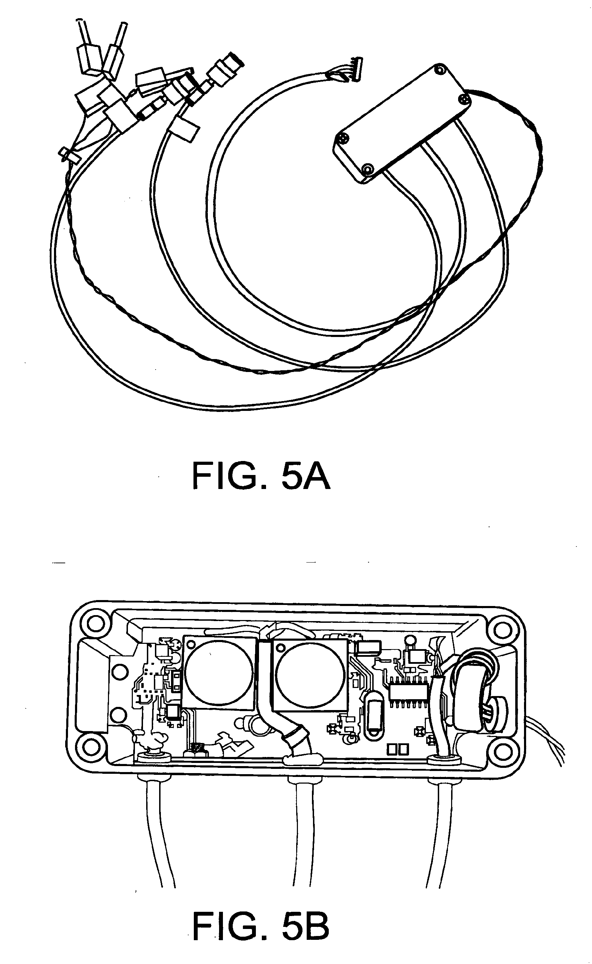

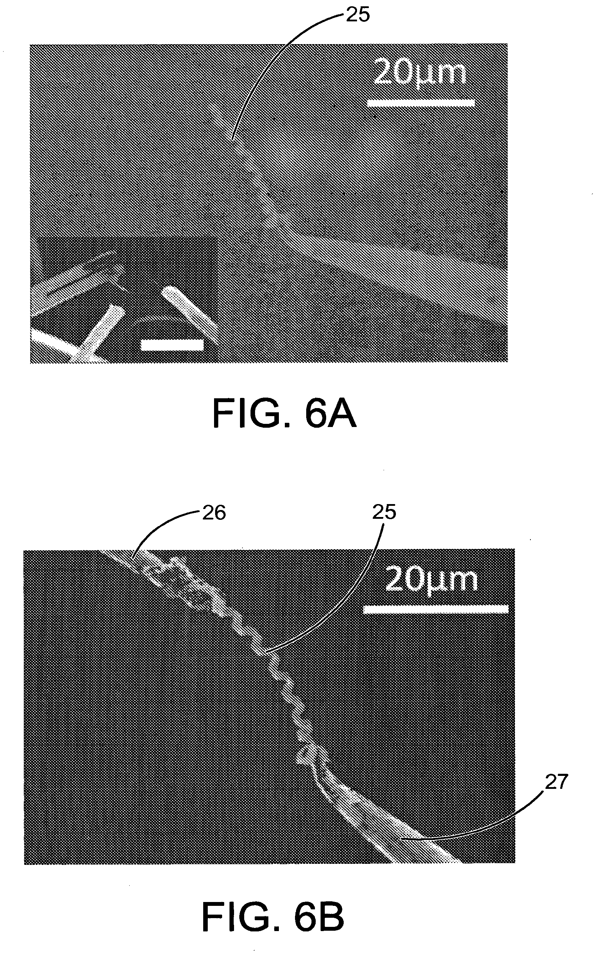

La figure 5A illustre une vue globale du premier exemple de réalisation du dispositif de l'invention illustré sur la figure 3 mis sous boîtier et prêt à être utilisé. La figure 5B illustre un détail d'une telle mise sous boitier. Les premier et second transformateurs TR_1 et TR_2 utilisés pour l'isolation galvanique 16 et 17 des étages d'excitation 15 et de préamplification 18 sont choisis de manière à être adaptés à la bande en fréquence du résonateur piézoélectrique. Dans la présente mise en oeuvre, le premier transformateur TR_1 est un transformateur à point symétrique qui présente un rapport de nombre de tours de bobinage 1:1+1, et pour chaque bobinage une inductance de 3 mH, une résistance DC de 1.3 ohms, une capacité interbobinage de 30pF (entre le primaire et le secondaire), une inductance de fuite de 8uH et un produit tension.temps de 200 V.us. Le second transformateur TR_2 présente un rapport de nombre de tours de bobinage 1:1 avec les mêmes caractéristiques électriques que le tranformateur TR_1. Ces caractéristiques des deux transformateurs permettent une réponse de gain unitaire de type passe-bande dans une plage en fréquence comprise entre 3kHz et 1 MHz. La sonde piézoélectrique 22 utilisée dans ce cas a une fréquence de résonance de 32kHz pour un facteur de qualité de 10 000.
Le dispositif électronique de la présente invention a été utilisé avec succès pour observer sous microscope électronique SEM et pour analyser en même temps l'effort mécanique d'un microsystème électromécanique (MEMS), par exemple un nanoressort 25 en extension, de type hélice obtenue par croissance contrôlée d'InGaAs/GaAs, comme illustré sur les figures 6A à 6E. Une extrémité de cette hélice 25 peut être connectée sur l'apex de la micropointe 26 de la sonde piézoélectrique. L'autre extrémité peut être connectée à une micropointe PicoProbe 27 reliée à un nanotranslateur pouvant opérer une extension ou une compression du nanoressort par pas discrets de quelques dizaines de nanomètres. Par ailleurs, les premier et second transformateurs TR_1 et TR_2 utilisés pour l'isolation galvanique 16 et 17 des étages d'excitation 15 et de préamplification 18 sont choisis de manière à supporter un choc électrique provoqué par le faisceau de particules chargées 12 dirigé sur la sonde piézoélectrique 11. Dans le cas présent, des tensions de claquage (primaire-secondaire) de 2 kiloVolts pour ces transformateurs TR_1 et TR_2 permettent d'isoler efficacement l'effet d'un faisceau électronique de 50 keV d'énergie d'accélération. Les images SEM des figures 6A à 6D ont été obtenues avec un faisceau électronique de 4 keV d'énergie d'accélération.

Les figures 6A et 6B représentent ainsi des images SEM de ce nanoressort 25 collé à ses deux extrémités entre la micropointe 26 de la sonde piézoélectrique (ici « diapason quartz Tuning Fork »), et la micropointe 27 du nanotranslateur Picoprobe.

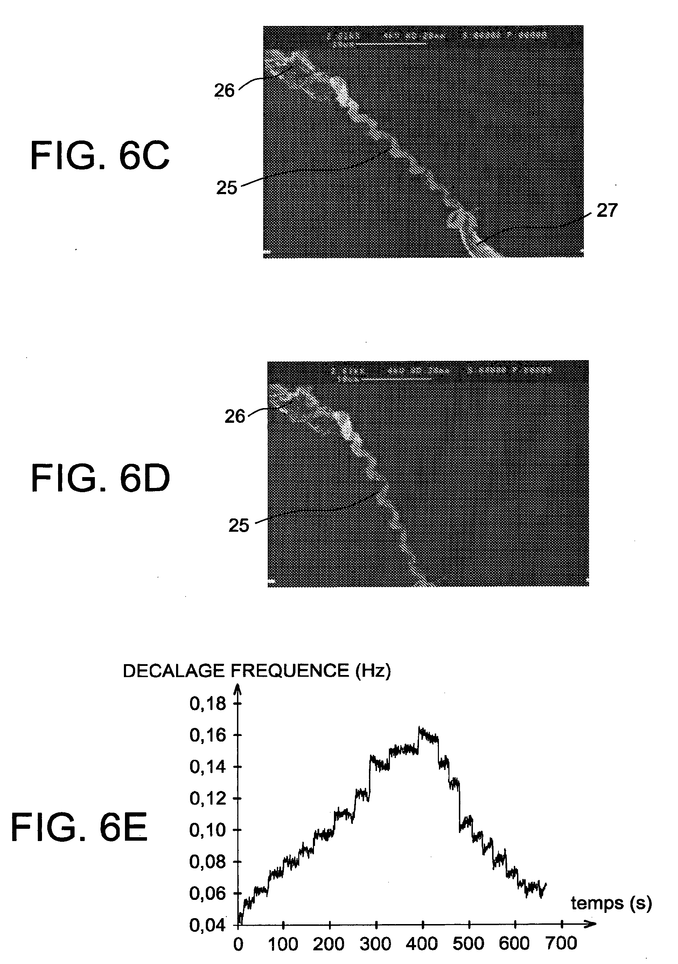

Les figures 6C et 6D représentent deux images SEM extraites du film acquis durant l'extension puis la compression au point initial du nanoressort 30.

La figure 6E représente une courbe de dérive en fréquence de la sonde piézoélectrique acquise simultanément grâce au dispositif électronique de la présente invention. On peut ainsi observer l'évolution de la dérive de la fréquence de résonance de la sonde piézoélectrique quand le nanoressort 25 est étiré au maximum de 1,5 $\mu$m puis comprimé à sa position initiale grâce au nanotranslateur.

Les pas discrets du nanotranslateur sont nettement visibles, avec le minimum et le maximum de la courbe de la figure 6E correspondant aux positions extrêmes des images illustrées sur les figures 6C et 6D.

Ce résultat démontre le suivi temps réel par imagerie SEM d'un microsystème électromécanique avec une mesure locale combinée des forces mise en jeu, par la mesure de la dérive en fréquence du résonateur piézoélectrique. Les pas en fréquence de la courbe de la figure 6E correspondent à un effort de 3 nanoNewton par pas du nanotranslateur.

## REFERENCES

[1] « Advances in atomic force microscopy » de Franz D. Giessibl (Review of Modern Physics, volume 75, juillet 2003, pages 949-983)

[2] « Transparently combining SEM, TEM and FIBS with AFM/SPM and NSOM » (Nanonics, Issue 2.3 (2002), http://nanonics.co.il/)

[3] US 2004/0216 518

[4] US 6,006,594

[5] « Electrostatic force microscopy using a quartz tuning fork » de Yongho Seo, Wonho Ihe et Cheol Seong Hwang (Applied Physics Letters, volume 80, numéro 23, 10 juin 2002, pages 4324 à 4326)

[6] Note technique « Midcom Transformer Theory », de Dave LeVasseur (Technical Note 69, June 1, 1998)

[7] Note technique de Rhombus Industries Inc. (« pulse transformers »)

[8] « Application Notes - Appendix 6 », p.24 , BH Electronics, www.bhelectronics.com

[9] « A Guide to Scanning Microscope Observation » (JEOL)

[10] "Scanning Probe Microscopy and Scanning Electron Microscopy for Electrical Characterization of Semiconductors" de J. C. Gonzalez, M. I. N. da Silva, K. L. Bunker and P.E. Russell, (Current Issues on Multidisciplinary Microscopy Research and Education, p.274, FORMATEX 2004)

[11] "Dielectric breakdown mechanisms in gate oxides" de S. Lombardo et al. (J. Appl. Phys. 98, 121301, 2005)

[12] "Gate oxide breakdown in FET devices and circuits: From nanoscale physics to system-level reliability" de B. Kaczer et al., (Microelectronics Reliability 47, 559-566, 2007).

## Revendications

1.    Dispositif électronique de pilotage d'une sonde locale à résonateur piézoélectrique (11) et de préamplification et traitement de ses signaux, cette sonde étant destinée à la mesure locale de propriétés physiques d'un échantillon (10) dans un environnement présentant un faisceau de particules (12) dirigé vers la sonde (11), **caractérisé en ce que** :

- une tension d'excitation générée par des moyens d'excitation (15) est appliquée au résonateur piézoélectrique (11) via un premier transformateur d'isolation galvanique (TR-1), et **en ce qu'**un courant. de mesure des oscillations mécaniques du résonateur piézoélectrique (11) est appliqué via un second transformateur d'isolation galvanique (TR_2) à des moyens de préamplification (18) situés en aval,
- les premier et second transformateurs ont une tension de claquage primaire/secondaire suffisament élevée pour supporter la surtension produite par le faisceau de particules,
- les bobinages des transformateurs présentent des impédances suffisament faibles pour que le courant électrique, provoqué dans les éléments conducteurs par l'impulsion électrique induite par le faisceau de particules, soit inapte à la détérioration du premier étage des moyens de préamplification placés en aval, et aux moyens d'excitation placés en amont.

2. Dispositif selon la revendication 1, dans lequel les bobinages primaire et secondaire des deux transformateurs (TR_1, TR_2) sont connectés au même potentiel électrique de masse.

3. Dispositif selon la revendication 1, dans lequel le faisceau de particules est un faisceau de particules électriquement chargées (12), qui est un faisceau électronique.

4. Dispositif selon la revendication 1, dans lequel le faisceau de particules est un faisceau de particules électriquement chargées (12), qui est un faisceau ionique.

5. Dispositif selon la revendication 1, dans lequel le faisceau de particules (12) est constitué de particules électriquement neutres du type atomes ou neutrons.

6. Dispositif selon la revendication 2 ou 3, dans lequel les transformateurs d'isolation galvanique (TR_1, TR_2) sont tels que le premier transformateur (TR_1) est un transformateur à point symétrique qui présente un rapport de nombre de tours de bobinage 1:1+1 et le second transformateur (TR_2) présente un rapport de nombre de tours de bobinage 1:1, avec les mêmes caractéristiques électriques que le premier transformateur (TR_1).

7. Dispositif selon l'une quelconque des revendications 2 ou 3, dans lequel les deux transformateurs (TR_1, TR_2) peuvent supporter un choc électrique provoqué par un faisceau de particules (12) dirigé sur la sonde (11).

8. Dispositif selon l'une quelconque des revendications 2 ou 3, dans lequel les bobinages primaire et secondaire des deux transformateurs (TR_1, TR_2) présentent une impédance largement inférieure à l'impédance d'entrée de l'amplificateur opérationnel de sortie U2.

9. Dispositif selon la revendication 2, dans lequel la sonde est munie d'une micropointe (22) conductrice apte à la mesure de forces, l'extrémité de cette micropointe (22) étant dotée d'un revêtement inorganique ou organique.

10. Dispositif selon la revendication 7, dans lequel l'échantillon est polarisé par rapport à la micropointe (22) reliée à la masse, l'échantillon étant électriquement relié à un convertisseur courant/tension afin de mesurer des propriétés physiques entre la pointe et l'échantillon.

11. Dispositif selon la revendication 8, qui comprend des moyens pour détecter la force électrostatique entre l'échantillon et la sonde par mesure EFM ou par mesure KPFM.

12. Dispositif selon la revendication 2, dans lequel la sonde est munie d'une micropointe (22) portant à son apex une microsphère d'un matériau magnétique rémanent aimanté permettant la mesure locale de forces magnétiques sur l'échantillon par mesure MFM.

13. Dispositif selon la revendication 2, dans lequel l'apex de la sonde est munie d'un thermocouple ou d'un fil de polymère.

**Patentansprüche**

1. Elektronische Vorrichtung zur Steuerung einer lokalen Sonde mit piezoelektrischem Resonator (11) und zur Vorverstärkung und Verarbeitung ihrer Signale, wobei diese Sonde für die lokale Messung von physikalischen Eigenschaften einer Probe (10) in einer Umgebung ausgelegt ist, die einen Partikelstrahl (12) aufweist, welcher auf die Sonde (11) gerichtet ist, **dadurch gekennzeichnet, dass**:

   - eine durch Anregungsmittel (15) erzeugte Anregungsspannung an den piezoelektrischen Resonator (11) über einen ersten Transformator mit galvanischer Isolierung (TR_1) angelegt ist, und dass ein Strom zur Messung mechanischer Oszillationen des piezoelektrischen Resonators (11) über einen zweiten Transformator mit galvanischer Isolierung (TR_2) an stromabwärts angeordnete Vorverstärkungsmittel (18) angelegt ist,
   - der erste und der zweite Transformator eine ausreichend hohe primäre/sekundäre Durchschlagspannung haben, um die durch den Partikelstrahl erzeugte Überspannung zu ertragen,
   - die Wicklungen der Transformatoren ausreichend niedrige Impedanzen aufweisen, damit der elektrische Strom, der in den Leiterelementen durch den vom Partikelstrahl induzierten elektrischen Puls erzeugt wird, die erste Stufe der stromabwärts platzierten Vorverstärkermittel und die stromaufwärts platzierten Anregungsmittel nicht beschädigen kann.

2. Vorrichtung nach Anspruch 1, bei der die primären und sekundären Wicklungen der zwei Transformatoren (TR_1, TR_2) an das gleiche elektrische Massepotential angeschlossen sind.

**3.** Vorrichtung nach Anspruch 1, bei der der Partikelstrahl ein Strahl von elektrisch geladenen Partikeln (12) ist, der ein Elektronenstrahl ist.

**4.** Vorrichtung nach Anspruch 1, bei der der Partikelstrahl ein Strahl von elektrisch geladenen Partikeln (12) ist, der ein Ionenstrahl ist.

**5.** Vorrichtung nach Anspruch 1, bei der der Partikelstrahl (12) aus elektrisch neutralen Partikeln vom Typ Atome oder Neutronen gebildet ist.

**6.** Vorrichtung nach Anspruch 2 oder 3, bei der die Transformatoren mit galvanischer Isolation (TR_1, TR_2) derart ausgelegt sind, dass der erste Transformator (TR_1) ein Transformator mit Symmetriepunkt ist, der ein Verhältnis der Zahl der Wicklungsumläufe 1:1+1 aufweist, und der zweite Transformator (TR_2) ein Verhältnis der Zahl der Wicklungsumläufe 1:1 aufweist, mit den gleichen elektrischen Eigenschaften wie der erste Transformator (TR_1).

**7.** Vorrichtung nach einem der Ansprüche 2 oder 3, bei der die zwei Transformatoren (TR_1, TR_2) einen Stromstoß ertragen können, der durch einen auf die Sonde (11) gerichteten Partikelstrahl (12) erzeugt wird.

**8.** Vorrichtung nach einem der Ansprüche 2 oder 3, bei der die primären und sekundären Wicklungen der zwei Transformatoren (TR_1, TR_2) eine Impedanz aufweisen, die wesentlich geringer ist als die Eingangsimpedanz des Ausgangsoperationsverstärkers U2.

**9.** Vorrichtung nach Anspruch 2, bei der die Sonde mit einer leitenden Mikrospitze (22) ausgestattet ist, die für die Messung von Kräften ausgelegt ist, wobei das Ende dieser Mikrospitze (22) mit einer anorganischen oder organischen Beschichtung versehen ist.

**10.** Vorrichtung nach Anspruch 7, bei der die Probe bezüglich der mit Masse verbundenen Mikrospitze (22) polarisiert ist, wobei die Probe elektrisch mit einem Strom/Spannungswandler verbunden ist, um physikalische Eigenschaften zwischen der Spitze und der Probe zu messen.

**11.** Vorrichtung nach Anspruch 8, die Mittel zur Erfassung der elektrostatischen Kraft zwischen der Probe und der Sonde durch EFM-Messung oder durch KPFM-Messung umfasst.

**12.** Vorrichtung nach Anspruch 2, bei der die Sonde mit einer Mikrospitze (22) ausgestattet ist, die an ihrer Apex eine Mikrokugel aus einem magnetisierten Remanenzmagnetmaterial trägt, was die lokale Messung von magnetischen Kräften auf die Probe durch MFM-Messung erlaubt.

**13.** Vorrichtung nach Anspruch 2, bei der die Apex der Sonde mit einem Thermoelement oder einem Polymerdraht ausgestattet ist.

**Claims**

**1.** Electronic control device for a local probe with piezoelectric resonator (11) and preamplification and processing of its signals, this probe being designed for local measurement of the physical properties of a sample (10) in an environment with a particle beam (12) directed towards the probe (11), **characterised in that**:

- an excitation voltage generated by excitation means (15) is applied to the piezoelectric resonator (11) through a first galvanic isolation transformer (TR_1), and **in that** a current for measurement of mechanical oscillations of the piezoelectric resonator (11) is applied through a second galvanic isolation transformer (TR_2) to preamplification means (18) on the output side,
- the first and second transformers have a sufficiently high primary/secondary breakdown voltage to resist the overvoltage generated by the particle beam,
- the impedances of the transformer windings are sufficiently low so that the electrical current generated in the conducting elements by the electrical pulse induced by the particle beam is incapable of damaging the first stage of the preamplification means placed on the output side, and the excitation means placed on the input side.

**2.** Device according to claim 1, in which the primary and secondary windings of the two transformers (TR_1, TR_2) are connected to the same electrical ground potential.

**3.** Device according to claim 1, in which the particle beam is an electrically charged particle beam (12), which is an electron beam.

**4.** Device according to claim 1, in which the particle beam is an electrically charged particle beam (12), which is an ion beam.

**5.** Device according to claim 1, in which the particle beam (12) is composed of electrically neutral particles such as atoms or neutrons.

**6.** Device according to claim 2 or 3, in which the galvanic isolation transformers (TR_1, TR_2) are such that the first transformer (TR_1) is a symmetric point transformer in which the ratio of the number of winding turns is 1:1+1 and the second transformer (TR_2) has a ratio of the number of winding turns 1:1, with the same electrical characteristics as the first transformer (TR_1).

7. Device according to any of claim 2 or 3, in which the two transformers (TR_1, TR_2) can resist an electric shock caused by a particle beam (12) directed onto the probe (11).

8. Device according to any of claim 2 or 3, in which the primary and secondary windings of the two transformers (TR_1, TR_2) have a much lower impedance than the input impedance to an output operational amplifier (U2).

9. Device according to claim 2, in which the probe is fitted with a conducting microtip (22) capable of measuring forces, the end of this microtip (22) being provided with an inorganic or organic coating.

10. Device according to claim 7, in which the sample is polarised relative to the microtip (22) connected to the ground, the sample being electrically connected to a current/voltage converter in order to measure physical properties between the tip and the sample.

11. Device according to claim 8, which comprises means of detecting the electrostatic force between the sample and the probe by EFM measurement or by KPFM measurement.

12. Device according to claim 2, in which the probe is fitted with a microtip (22) with a microsphere made of a magnetised remanent magnetic material at its apex, capable of local measurement of magnetic forces on the sample by MFM.

13. Device according to claim 2, in which the apex of the probe is fitted with a thermocouple or a polymer wire.

FIG. 1

FIG. 2

FIG. 3

EP 2 529 239 B1

FIG. 4

FIG. 5A

FIG. 5B

**FIG. 6A**

**FIG. 6B**

FIG. 6C

FIG. 6D

FIG. 6E

DECALAGE FREQUENCE (Hz)

temps (s)

## RÉFÉRENCES CITÉES DANS LA DESCRIPTION

**Documents brevets cités dans la description**

- US 20040216518 A

- US 6006594 A

**Littérature non-brevet citée dans la description**

- **DE FRANZ D. GIESSIBL.** Advances in atomic force microscopy. *Review of Modern Physics,* Juillet 2003, vol. 75, 949-983
- Transparently combining SEM, TEM and FIBS with AFM/SPM and NSOM. *Nanonics,* 2002, http://nanonics.co.il/
- **DE YONGHO SEO ; WONHO IHE ; CHEOL SEONG HWANG.** Electrostatic force microscopy using a quartz tuning fork. *Applied Physics Letters,* 10 Juin 2002, vol. 80 (23), 4324-4326
- **DE DAVE LEVASSEUR.** Midcom Transformer Theory. *Technical Note 69,* 01 Juin 1998
- *pulse transformers*
- Application Notes - Appendix 6. BH Electronics, 24

- *A Guide to Scanning Microscope Observation*
- **DE J. C. GONZALEZ ; M. I. N. DA SILVA ; K. L. BUNKER ; P.E. RUSSELL.** Scanning Probe Microscopy and Scanning Electron Microscopy for Electrical Characterization of Semiconductors. *Current Issues on Multidisciplinary Microscopy Research and Education,* 2004, 274
- **DE S. LOMBARDO et al.** Dielectric breakdown mechanisms in gate oxides. *J. Appl. Phys.,* 2005, vol. 98, 121301
- **DE B. KACZER et al.** Gate oxide breakdown in FET devices and circuits: From nanoscale physics to system-level reliability. *Microelectronics Reliability,* 2007, vol. 47, 559-566